# EUROPEAN PATENT APPLICATION

(11) **EP 4 057 781 A1**
(43) Date of publication of application: **14.09.2022**
(21) Application number: 22159872.5
(22) Date of filing: 03.03.2022
(51) Int. Cl.: H05K 1/18, H05K 1/02, H05K 3/10, H05K 3/34

(54) **WIRELESS POWER SUPPLY WIRING CIRCUIT BOARD AND BATTERY MODULE**

(30) Priority: 09.03.2021 JP 2021037707
(71) Applicant: Nitto Denko Corporation, Ibaraki-shi, Osaka 567-8680 (JP)
(72) Inventor: TSUDA, Hisashi, Ibaraki-shi, 567-8680 (JP); ICHIKAWA, Kazushi, Ibaraki-shi, 567-8680 (JP); SASAKI, Takashi, Ibaraki-shi, 567-8680 (JP); SUZUKI, Masafumi, Ibaraki-shi, 567-8680 (JP)
(74) Representative: Müller-Boré & Partner Patentanwälte PartG mbB

(57) **Abstract**

Outflow of sealing resin is prevented and mounting strength is improved. A wireless power supply wiring circuit board 1 includes a first insulating layer 11, a conductive layer 16 that is provided on one surface in the thickness direction of the first insulating layer 11 and includes a wiring portion 161, a transceiver circuit portion 13 that is electrically connected to the wiring portion 161, a component mounting portion 2 which is provided on the other surface in the thickness direction of the first insulating layer 11 and on which an electronic component 3 electrically connected to the wiring portion 161 is mounted, and a metal dam portion 121 provided around at least part of the component mounting portion 2.

## Description

### BACKGROUND OF THE INVENTION

The present invention relates to a wireless power supply wiring circuit board and a battery module.

Due to recent downsizing and thinning of electronic apparatuses and development of foldable mobile phone terminals, electronic devices mounted on the electronic apparatuses and circuit boards for mounting the electronic devices are required to have a high degree of integration and high flexibility. A gap between an electronic device and a circuit board is typically filled with sealing resin (underfill) in order to, for example, secure the insulation of the circuit and achieve protection from external force. In this regard, when the degree of integration of the electronic device and the circuit board is increased and the number of bending portions of the circuit board is increased, a possibility of outflow of the sealing resin from between the electronic device and the circuit board is increased.

As the outflow of the sealing resin advances, a possibility of occurrence of problems increases. Examples of the problems include a malfunction of the electronic apparatus as an electrode of the circuit board is disadvantageously covered with the sealing resin and peeling-off of a layer (so-called delamination) due to application of stress caused by the sealing resin adhered to the circuit board. In order to prevent the occurrence of such problems, a technology of preventing outflow of sealing resin has been proposed (e.g., by Patent Literature 1 (Japanese Unexamined Patent Publication No. 2011-97060)).

Patent Literature 1 discloses a flip chip package in which a dam portion is formed at a groove formed by partially removing a resin layer, in order to prevent the outflow of sealing resin. This dam portion prevents the outflow of the sealing resin injected in a gap between the resin layer and an electronic device provided above the resin layer.

### SUMMARY OF THE INVENTION

When the dam portion is formed by the method described above, because the dam portion is formed at the groove formed by partially removing the resin layer where the dam portion is to be formed, the strength of the dam portion may be insufficient to deal with the external force, if there is a gap between the groove and the dam portion.

An object of the present invention is to provide a wireless power supply wiring circuit board which prevents the outflow of sealing resin and improves mounting strength.

A wireless power supply wiring circuit board of the present invention includes:
an insulating layer;
a conductive layer which is provided on one surface in a thickness direction of the insulating layer and includes a wiring portion;
a transceiver circuit portion which is electrically connected to the wiring portion;
a component mounting portion which is provided on an other surface in the thickness direction of the insulating layer, an electronic component electrically connected to the wiring portion being mounted on the component mounting portion; and
a dam portion which is made of metal and is provided around at least part of the component mounting portion.

According to the arrangement above, because the dam portion is formed without requiring a groove to be formed in the top surface of the insulating layer, no gap is formed between the dam portion and the insulating layer. It is therefore possible to prevent the outflow of the sealing resin and to improve the mounting strength.

The wireless power supply wiring circuit board of the present invention may be arranged such that,
the component mounting portion has a planar mounting surface on which the electronic component electrically connected to the wiring portion through a conductive portion is mounted, and
the conductive portion is flush with the mounting surface of the component mounting portion.

According to the arrangement above, because the mounting surface on which the electronic component is mounted is flush with the conductive portion, the efficiency in mounting of the electronic component is improved.

The wireless power supply wiring circuit board of the present invention may be arranged such that the dam portion may be rectangular in shape in cross section.

With this arrangement, because the width of the dam portion does not increase toward the bottom, a large number of circuits and electronic devices can be provided on the board. It is therefore possible to increase the degree of integration of the wireless power supply wiring circuit board.

The wireless power supply wiring circuit board of the present invention may be arranged such that the dam portion is made of stainless steel.

According to this arrangement, because the dam portion is made of stainless steel having high corrosion resistance, the corrosion resistance of the wireless power supply wiring circuit board is improved.

The wireless power supply wiring circuit board of the present invention may be arranged such that height of the dam portion falls within a range of 1 µm to 100 µm.

With this arrangement, outflow of the sealing resin is prevented and at the same time the degree of integration of the wireless power supply wiring circuit board is improved.

The wireless power supply wiring circuit board of the present invention may be arranged such that a distance a between the component mounting portion and the dam portion and a vertical distance b between a top surface of the component mounting portion and a top surface of a package of the electronic component satisfy a relationship of b/10<=a<=b.

With this arrangement, flexibility and the degree of integration of the wireless power supply wiring circuit board are improved.

In addition to the above, a battery module of the present invention includes: the wireless power supply wiring circuit board; and a battery which is connected to the wireless power supply wiring circuit board.

This arrangement makes it possible to downsize the battery module.

The present invention makes it possible to prevent outflow of sealing resin and improve mounting strength.

### BRIEF DESCRIPTION OF THE DRAWINGS

FIG. 1 schematically shows a top surface of a wireless power supply wiring circuit board of an embodiment.
FIG. 2 is an end view taken along a line A-A in FIG. 1.
FIG. 3A illustrates a manufacturing process of the wireless power supply wiring circuit board of the embodiment.
FIG. 3B illustrates the manufacturing process of the wireless power supply wiring circuit board of the embodiment.
FIG. 3C illustrates the manufacturing process of the wireless power supply wiring circuit board of the embodiment.
FIG. 3D illustrates the manufacturing process of the wireless power supply wiring circuit board of the embodiment.
FIG. 3E illustrates the manufacturing process of the wireless power supply wiring circuit board of the embodiment.
FIG. 3F illustrates the manufacturing process of the wireless power supply wiring circuit board of the embodiment.
FIG. 3G illustrates the manufacturing process of the wireless power supply wiring circuit board of the embodiment.
FIG. 3H illustrates the manufacturing process of the wireless power supply wiring circuit board of the embodiment.
FIG. 3I illustrates the manufacturing process of the wireless power supply wiring circuit board of the embodiment.
FIG. 3J illustrates the manufacturing process of the wireless power supply wiring circuit board of the embodiment.
FIG. 3K illustrates the manufacturing process of the wireless power supply wiring circuit board of the embodiment.
FIG. 3L illustrates the manufacturing process of the wireless power supply wiring circuit board of the embodiment.
FIG. 4 is a perspective view of a battery module.

### DESCRIPTION OF THE PREFERRED EMBODIMENTS

The following will describe a wireless power supply wiring circuit board of an embodiment of the present invention.

### (Wireless Power Supply Wiring Circuit Board: Planar Structure)

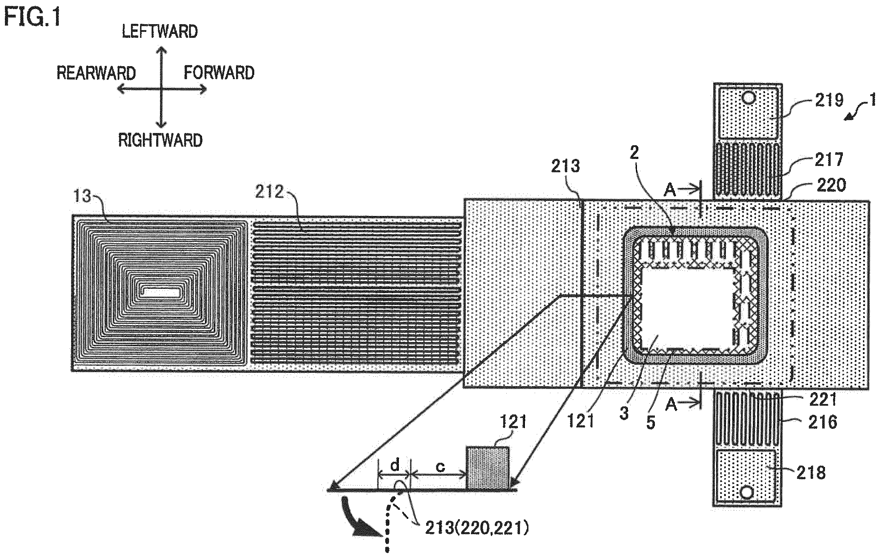

FIG. 1 schematically shows a top surface of a wireless power supply wiring circuit board 1.

The wireless power supply wiring circuit board 1 is strip-shaped and includes a transceiver circuit portion 13, a first wiring passage portion 212, and a component mounting portion 2 that are provided in this order from one end portion in the longitudinal direction. The transceiver circuit portion 13 has a function as a power-receiving coil that converts an electromagnetic wave to electric power. The first wiring passage portion 212 has a function of distributing powers and signals. On the surface of the component mounting portion 2, an electronic component 3 is mounted. At both end portions in the width direction of the component mounting portion 2, electrode terminal portions 218 and 219 are provided through the intermediary of second wiring passage portions 216 and 217. The electrode terminal portions 218 and 219 are electrically connected to a positive electrode terminal and a negative electrode terminal, respectively. The positive electrode terminal and the negative electrode terminal are on one surface and the other surface of a button-shaped secondary battery, respectively. The first wiring passage portion 212 and the second wiring passage portions 216 and 217 are provided with a first bending portion 213 and second bending portions 220 and 221, respectively. Each bending portion has a one side substrate structure.

### (Wireless Power Supply Wiring Circuit Board: Lamination Structure of Component Mounting Portion)

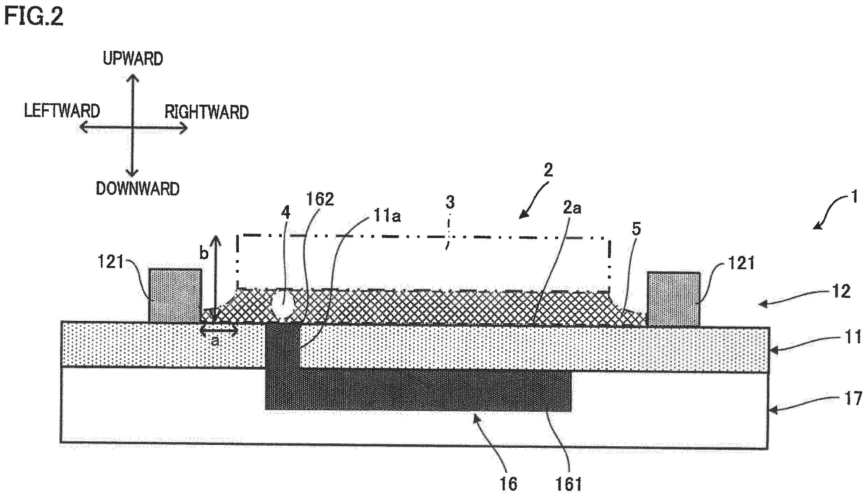

FIG. 2 is an end view taken along a line A-A in FIG. 1 and shows the lamination structure of an area including the component mounting portion 2. The wireless power supply wiring circuit board 1 includes a first insulating layer 11 that is an insulating layer of the present invention, a conductive layer 16 that is provided on a bottom surface of the first insulating layer 11 on one side in the thickness direction, and a second insulating layer 17 provided to cover the conductive layer 16. The conductive layer 16 has a wiring portion 161 functioning as a path of a current, and the wiring portion 161 is electrically connected at least to the transceiver circuit portion 13. While in the present embodiment one side in the thickness direction indicates the lower side, one side in the thickness direction may indicate the upper side.

The wireless power supply wiring circuit board 1 includes the component mounting portion 2 that is provided on a top surface of the first insulating layer 11 on the other side in the thickness direction. On the component mounting portion 2, the electronic component 3 is mounted to be electrically connected to the wiring portion 161. In the component mounting portion. 2, the electronic component 3 and the wiring portion 161 are electrically connected to each other through a connecting member 4. To be more specific, the wiring portion 161 is electrically connected to the electronic component 3 in such a way that a bottom surface of the connecting member 4 is connected to a top surface of the wiring portion 161 and a top surface of the connecting member 4 is connected to an electrode portion of the electronic component 3. An example of the connecting member 4 is a solder ball. Examples of the electronic component 3 include an integrated circuit, a resistor, and a capacitor.

A gap between a mounting surface 2a of the component mounting portion 2 and the electronic component 3 is filled with sealing resin 5. The sealing resin 5 is provided to suppress decrease in reliability of the electric connection between the wiring portion 161 and the electronic component 3. To be more specific, the sealing resin 5 suppresses electrical connection error due to a crack of the connecting member 4, which is caused by, for example, stress generated due to a difference between a thermal expansion coefficient of a material of the wireless power supply wiring circuit board 1 and a thermal expansion coefficient of a material of the electronic component 3 and external stress due to bending of the wireless power supply wiring circuit board 1. As the sealing resin 5 is injected into the gap between the mounting surface 2a of the component mounting portion 2 and the electronic component 3, the resin permeates the gap between the mounting surface 2a of the component mounting portion 2 and the electronic component 3 and its surroundings on account of the capillary phenomenon, and the resin is thermally set. An example of the sealing resin 5 is one-pack type thermosetting epoxy resin.

As described above, the gap between the mounting surface 2a of the component mounting portion 2 and the electronic component 3 is filled with the sealing resin 5. Because the sealing resin is liquid before it is thermally set, the outflow of the resin may be excessive. For example, when the sealing resin 5 outflows to a part different from the gap between the mounting surface 2a of the component mounting portion 2 and the electronic component 3, poor adhesion of layers occurs due to permeation of the sealing resin 5 into gaps between layers such as the first insulating layer 11 and the conductive layer 16, with the result that, for example, peeling-off of the first insulating layer 11 (so-called delamination) may occur. Furthermore, assume that the sealing resin 5 reaches a bending portion in the vicinity of the component mounting portion 2 and cures. In this case, when the circuit board 1 is bended, the stress of the bending may cause the first insulating layer 11 to be peeled off from the conductive layer 16 as the sealing resin 5 is closely in contact with the first insulating layer 11.

In consideration of the problem above, a dam portion 121 is provided around the component mounting portion 2. The dam portion 121 blocks the sealing resin 5 outflowing from the component mounting portion 2 in order to prevent the occurrence of the problems such as delamination.

### (Wireless Power Supply Wiring Circuit Board: Dam Portion)

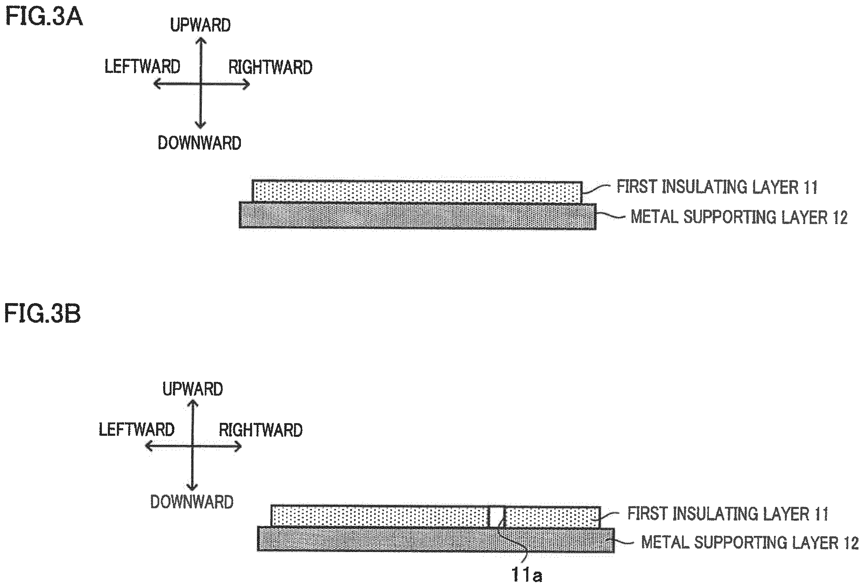

The dam portion 121 is provided on the top surface of the first insulating layer 11 to surround the component mounting portion 2. The dam portion 121 is made of metal. This metal preferably excels in corrosion resistance. In particular, the dam portion 121 is preferably formed of metal including stainless steel. Furthermore, the dam portion 121 is preferably part of a metal supporting layer 12 (see, e.g., FIG. 3A) that reinforces the wireless power supply wiring circuit board 1. This is because, when the metal supporting layer 12 is partially etched to form the dam portion 121 in a process of manufacturing the wireless power supply wiring circuit board 1 by depositing layers such as the first insulating layer 11 onto the metal supporting layer 12, the bonding strength between the metal dam portion 121 and the first insulating layer 11 is high as compared to a case where the dam portion 121 is individually formed by, for example, applying a metal material onto the first insulating layer 11.

The dam portion 121 may at least partially surround the component mounting portion 2. In other words, the dam portion 121 may be provided at a part of the outer circumference of the component mounting portion 2. The dam portion 121 may continuously or intermittently surround the component mounting portion 2.

The dam portion 121 is formed to be rectangular in shape in a cross section cut along the width direction (left-right direction in the figure). The cross sectional shape of the dam portion 121 may be quadrangular, rectangular, trapezoidal, triangular, elliptical, or another shape. Preferably, with the cross sectional shape, two conditions, i.e., an amount of blocked sealing resin 5 and strength of bonding to the first insulating layer 11, are equal to or higher than predetermined design values.

The height of the dam portion 121 is arranged to fall within a range of 1 to 100 µm. Preferably, this height falls within a range of 10 to 70 µm. With this height, outflow of the sealing resin 5 is prevented and at the same time the degree of integration of the wireless power supply wiring circuit board 1 is improved. The width of the dam portion preferably falls within a range of 0.005 to 5 mm. With this width, outflow of the sealing resin 5 is prevented and at the same time the degree of integration of the wireless power supply wiring circuit board 1 is improved.

Preferably, the distance a between the dam portion 121 and the electronic component 3 of the component mounting portion 2 and the distance b between the mounting surface 2a of the component mounting portion 2 and the top surface of the electronic component 3 satisfy the relationship b/10<=a<=b. In this case, flexibility and the degree of integration of the wireless power supply wiring circuit board 1 are improved.

The distance between the dam portion 121 and a bending portion (the first bending portion 213 or the second bending portions 220 and 221) is preferably arranged not to be influenced by tensile stress that is generated on the outer side of the bending portion when the circuit board is bended at the bending portion. This is because, when influenced by tensile stress, the dam portion 121 joined with the first insulating layer 11 is positionally deviated, and the first insulating layer 11 may be deformed.

As shown in FIG. 1, the distance between the dam portion 121 and a bending portion (the first bending portion 213 or the second bending portions 220 and 221) is preferably equal to or longer than the length d of the bending portion. The length d of the bending portion is the length in the front-rear direction of a curved surface when the bending portion is bended. This is because distortion generated by bending is resolved and the influence of the tensile stress is sufficiently reduced. The bending portion is preferably formed to have lower rigidity than other portions so that bending is facilitated. For example, the bending portion may be shaped to be thinner than other portions, or may be arranged so that wires in two or more layers are integrated into one layer, when wires are provided in plural layers.

### (Wireless Power Supply Wiring Circuit Board: First Insulating Layer)

The first insulating layer 11 has a function of supporting other components of the wireless power supply wiring circuit board 1 such as the dam portion 121 and mounted components such as the electronic component 3, the connecting member 4, and the sealing resin 5. The first insulating layer 11 is made of polyimide resin. For example, the first insulating layer 11 may be made of an insulative material such as synthetic resin such as polyamide-imide resin, acrylic resin, polyether nitrile resin, polyether sulfone resin, polyethylene terephthalate resin, polyethylene naphthalate resin, and polyvinyl chloride resin.

In an area of the first insulating layer 11 corresponding to the component mounting portion 2, an opening portion 11a is formed to penetrate the layer in the thickness direction. In the area corresponding to the component mounting portion 2, the top surface of the first insulating layer 11 functions as the mounting surface 2a of the component mounting portion 2.

The opening portion 11a forms a conductive portion 162 when it is filled with a conductive material. An upper end face and a lower end face of the conductive portion 162 are connected to the connecting member 4 on the top surface of the first insulating layer 11 and the wiring portion 161 on the bottom surface of the first insulating layer 11, respectively. As the conductive portion 162 electrically connects the connecting member 4 with the wiring portion 161, the wireless power supply wiring circuit board 1 is able to supply DC power output from a battery module 411 to the electronic component 3 through the connecting member 4, the conductive portion 162, and the wiring portion 161. The number of conductive portions 162 (opening portions 11a) may be more than one.

The upper end face of the conductive portion 162 is flush with the planar mounting surface 2a of the component mounting portion 2, which is the top surface of the first insulating layer 11. With this arrangement, poor soldering on the wireless power supply wiring circuit board 1 is prevented as a proper amount of the connecting member 4 such as a solder ball is retained on the upper end face of the conductive portion 162.

### (Wireless Power Supply Wiring Circuit Board: Conductive Layer and Second Insulating Layer)

On the bottom surface of the first insulating layer 11, the conductive layer 16 is provided. The conductive layer 16 includes the wiring portion 161 where an alternate current converted from an electromagnetic wave, a current discharged from a secondary battery, and various types of signal currents flow. The conductive layer 16 is made of copper. Alternatively, for example, the conductive layer 16 may be made of metal such as aluminum, nickel, gold, or alloy of these metals.

The bottom surface and side surfaces of the conductive layer 16 are covered with the second insulating layer 17. The second insulating layer 17 is provided on the bottom surface of the first insulating layer 11. The second insulating layer 17 is made of polyimide resin. Alternatively, for example, the second insulating layer 17 may be made of an insulative material such as synthetic resin such as polyamide-imide resin, acrylic resin, polyether nitrile resin, polyether sulfone resin, polyethylene terephthalate resin, polyethylene naphthalate resin, and polyvinyl chloride resin.

### (Wireless Power Supply Wiring Circuit Board: Manufacturing Process)

A manufacturing process of manufacturing the wireless power supply wiring circuit board 1 of the present embodiment will be described with reference to FIG. 3A to FIG. 3L. The manufacturing process of the present embodiment is a mere example, and does not restrict the manufacturing process of manufacturing the wireless power supply wiring circuit board of the present invention.

As shown in FIG. 3A, the first insulating layer 11 that is a photosensitive base film is formed on the top surface of the metal supporting layer 12. The metal supporting layer 12 is made of stainless steel and includes the dam portion 121 and a non-dam portion (not illustrated) . The non-dam portion is removed in subsequent etching. The first insulating layer 11 is formed by applying varnish made of photosensitive polyimide resin onto the top surface of the metal supporting layer 12 and drying the varnish.

Subsequently, as shown in FIG. 3B, a first insulating layer photomask (not illustrated) in which a pattern of the opening portion 11a is depicted is applied to the top surface of the first insulating layer 11, and a process of exposure and development is performed. To be more specific, the first insulating layer photomask has a light transmissive portion allowing ultraviolet light to pass through and a light blocking portion blocking ultraviolet light, and the pattern of the opening portion 11a is depicted in such a way that a portion below which the opening portion 11a is to be formed is the light blocking portion and the remaining portion is the light transmissive portion. As the first insulating layer photomask in which the pattern is depicted is exposed to ultraviolet light, a part of the first insulating layer 11 below the light transmissive portion of the first insulating layer photomask is cured by the exposure. Meanwhile, a part of the first insulating layer 11 below the light blocking portion of the first insulating layer photomask is not cured. As the first insulating layer 11 after the exposure is developed by using a developing liquid such as sodium carbonate, the opening portion 11a is formed in the first insulating layer 11. Thereafter, an unillustrated seed film is formed on the top surface of the first insulating layer 11 and the side surface of the opening portion 11a. Examples of a method of forming the seed film include sputtering, electrolytic plating, and electroless plating. The method is preferably sputtering. Examples of the material of the seed film include metals such as copper, chromium, and nickel, and alloy of these metals.

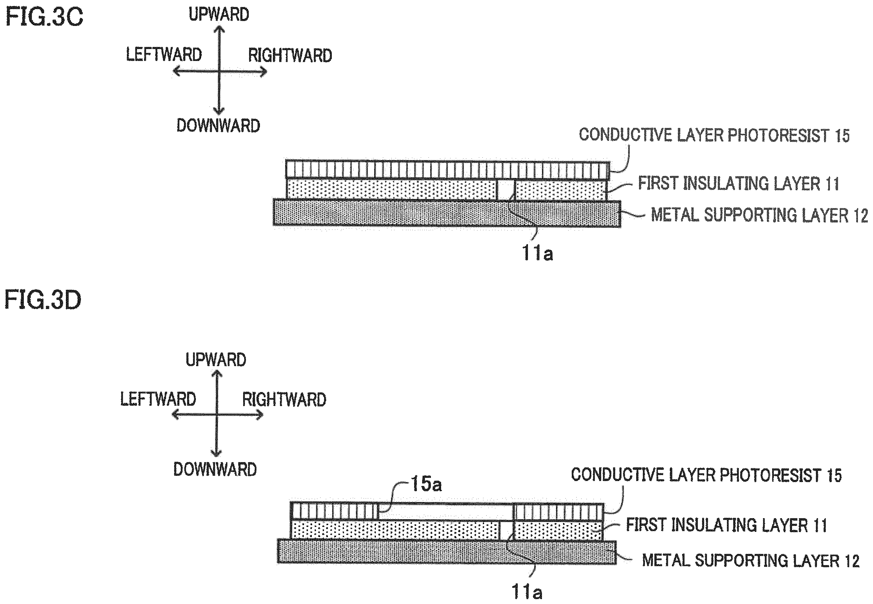

Subsequently, as shown in FIG. 3C, a conductive layer photoresist 15 is formed on the top surface of the first insulating layer 11 where the seed film has been formed. Subsequently, a conductive layer photomask (not illustrated) is applied to the top surface of the conductive layer photoresist 15, and a process of exposure and development is performed. To be more specific, the conductive layer photomask has a light transmissive portion allowing ultraviolet light to pass through and a light blocking portion blocking ultraviolet light, and a pattern in which a portion below which the wiring portion 161 is to be formed is the light blocking portion and the remaining portion is the light transmissive portion is depicted in this photomask. As the conductive layer photomask in which the pattern is depicted is exposed to ultraviolet light, a part of the conductive layer photoresist 15 below the light transmissive portion of the conductive layer photomask is cured by the exposure. Meanwhile, a part of the conductive layer photoresist 15 below the light blocking portion of the conductive layer photomask is not cured. The conductive layer photoresist 15 after the exposure is developed by using a developing liquid such as sodium carbonate. Consequently, as shown in FIG. 3D, a part where the wiring portion 161 is to be formed is removed from the conductive layer photoresist 15 and an opening portion 15a is formed.

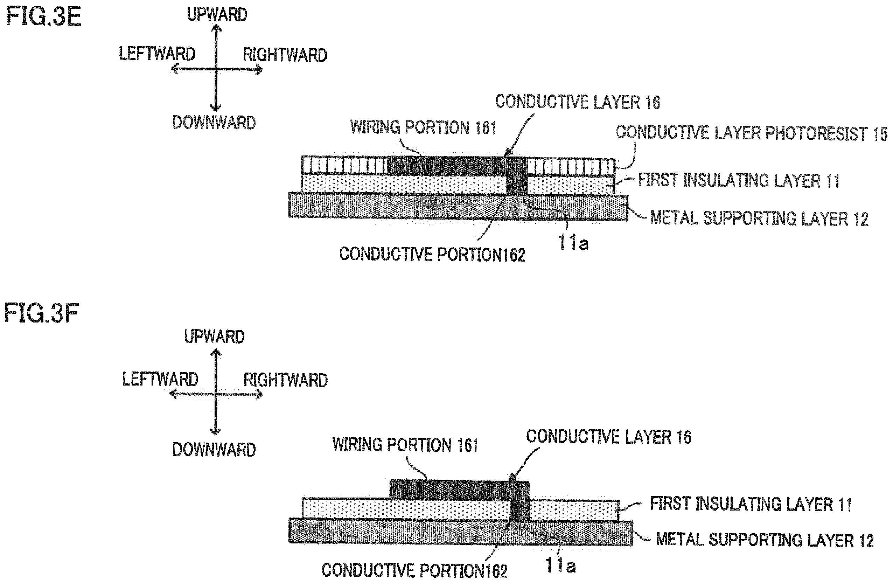

Subsequently, as shown in FIG. 3E, the conductive portion 162 is formed at the opening portion 11a of the first insulating layer 11 and the wiring portion 161 of the conductive layer 16 is formed at the opening portion 15a of the conductive layer photoresist 15. To be more specific, after a thin copper film is formed on the top surface of the first insulating layer 11 by dry plating, the conductive layer 16 is formed by electrolytic plating by using the thin copper film as an electrode. After the formation of the conductive layer 16, the remaining conductive layer photoresist 15 is removed as shown in FIG. 3F. Then the seed film on the bottom surface of the conductive layer photoresist 15 is removed by known etching (e.g., wet etching).

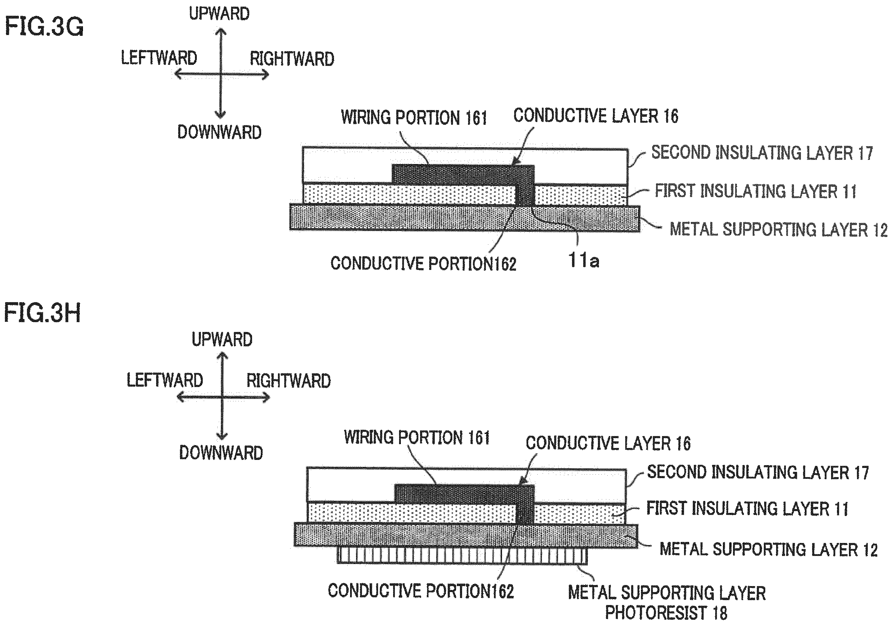

Subsequently, as shown in FIG. 3G, a photosensitive second insulating layer 17 is formed on the top surfaces of the first insulating layer 11 and the conductive layer 16. The second insulating layer 17 is formed by applying varnish made of photosensitive polyimide resin onto the top surfaces of the first insulating layer 11 and the conductive layer 16 and drying the varnish.

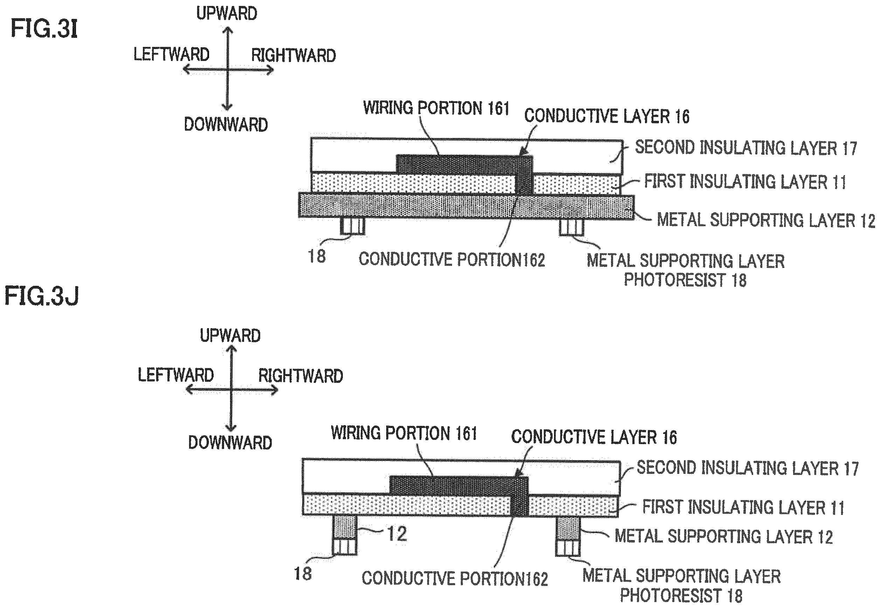

Subsequently, as shown in FIG. 3H, a metal supporting layer photoresist 18 is formed on the bottom surface of the metal supporting layer 12. Subsequently, a metal supporting substrate photomask (not illustrated) is applied to the bottom surface of the metal supporting layer photoresist 18, and a process of exposure and development is performed. To be more specific, the metal supporting substrate photomask has a light transmissive portion allowing ultraviolet light to pass through and a light blocking portion blocking ultraviolet light, and a pattern of the dam portion 121 in which a portion where the dam portion 121 is to be formed is the light transmissive portion and the remaining portion (non-dam portion 121) is the light blocking portion is depicted on the metal supporting substrate photomask. As the metal supporting substrate photomask in which the pattern is depicted is exposed to ultraviolet light, a part of the metal supporting layer photoresist 18 above the light transmissive portion of the metal supporting substrate photomask i-s cured by the exposure. Meanwhile, a part of the metal supporting layer photoresist 18 above the light blocking portion of the metal supporting substrate photomask is not cured. As the metal supporting layer photoresist 18 after the exposure is developed by using a developing liquid such as sodium carbonate, the pattern of the dam portion is depicted on the metal supporting layer photoresist 18 as shown in FIG. 3I.

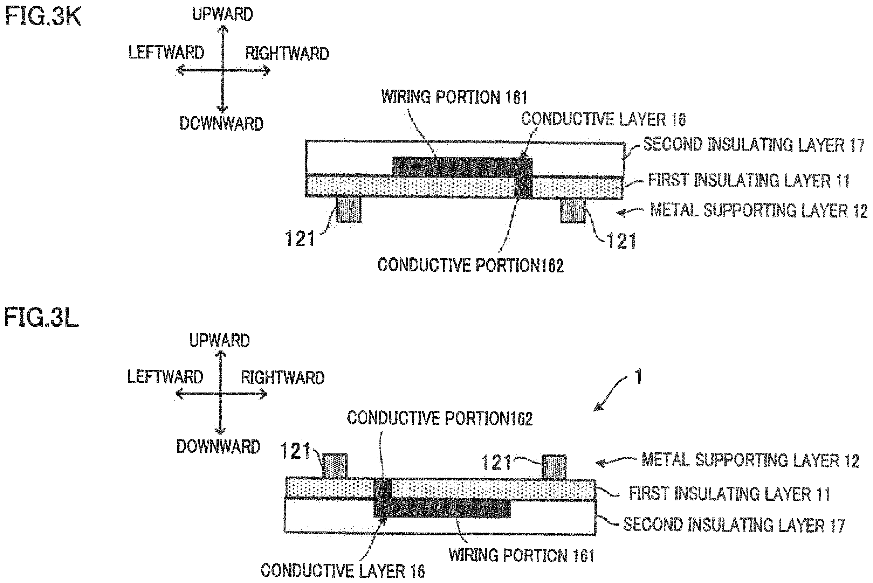

Subsequently, the non-dam portion is removed by etching and the dam portion 121 is formed in the metal supporting layer 12 as shown in FIG. 3J. In other words, the dam portion 121 is formed by not removing part of the metal supporting layer 12. In addition to this, because the flat metal supporting layer 12 is removed, the upper end face of the conductive portion 162 of the first insulating layer 11 deposited on the top surface of the metal supporting layer 12 is flat and flush with the first insulating layer 11. The metal supporting layer photoresist 18 remaining below the dam portion 121 is removed after the etching, as shown in FIG. 3K. As the power supply wiring circuit board 1 shown in FIG. 3K is rotated by 180 degrees along the cross section taken along the A-A line in FIG. 1, the power supply wiring circuit board 1 shown in FIG. 3L is formed, and the manufacturing process finishes.

The wireless power supply wiring circuit board 1 manufactured in the manner as described above includes, as shown in FIG. 2, the first insulating layer 11 that is an insulating layer of the present invention, the conductive layer 16 that is provided on one surface in the thickness direction of the first insulating layer 11 and includes the wiring portion 161, the transceiver circuit portion 13 that is electrically connected to the wiring portion 161 and shown in FIG. 1, the component mounting portion 2 which is provided on the other surface in the thickness direction of the first insulating layer 11 and on which the electronic component 3 electrically connected to the wiring portion 161 is mounted, and the metal dam portion 121 provided around at least part of the component mounting portion 2.

According to the arrangement above, the outflow of the sealing resin 5 with which the gap between the component mounting portion 2 and the electronic component 3 is filled is blocked by the inner side walls of the dam portion 121. It is therefore possible to suppress problems such as the occurrence of delamination due to permeation of the sealing resin 5 outflowing from the component mounting portion 2 into the layers and the occurrence of poor electrical properties of the wireless power supply wiring circuit board 1. According to the arrangement above, furthermore, because it is possible to prevent the sealing resin 5 from reaching the bending portion in the vicinity of the component mounting portion 2 and curing, it is possible to prevent the first insulating layer 11 from being peeled off from the conductive layer 16 due to the stress caused by the bending of the circuit board 1. According to the arrangement above, furthermore, because the mounting surface 2a of the component mounting portion 2 is flush with the top surface of the conductive portion 162, poor soldering is suppressed and the efficiency in mounting of the electronic component 3 is improved.

The dam portion 121 is formed in such a way that the first insulating layer 11 is integrally formed by utilizing an anchor effect on the metal supporting layer 12 composed of a stainless steel thin film and a film, and then unnecessary part is removed by etching. With this arrangement, no gap is formed between the first insulating layer 11 (the mounting surface 2a of the component mounting portion 2) and the dam portion 121. On this account, the dam portion 121 that is highly resistant to external force can be formed as compared to a case where the dam portion 121 is attached by means of an adhesive, etc. to a groove formed by partially removing the top surface of the first insulating layer 11.

### (Method of Forming Battery Module by Using Wireless Power Supply Wiring Circuit Board)

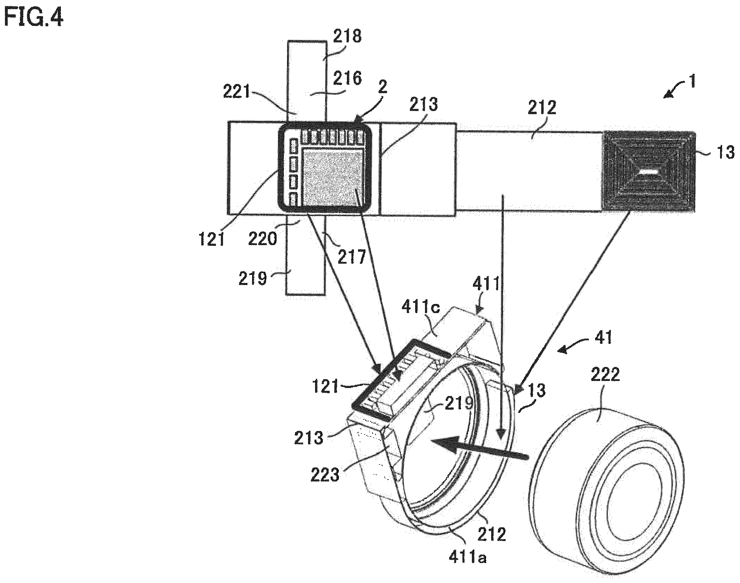

As shown in FIG. 4, the wireless power supply wiring circuit board 1 includes the transceiver circuit portion 13, the first wiring passage portion 212, and the component mounting portion 2. On the side opposite to the mounting portion 2 over the first bending portion 213, the wireless power supply wiring circuit board 1 is provided with another component mounting portion 223. This component mounting portion 223 is provided on the bottom surface side that is the secondary battery 222 side.

The component mounting portion 2 includes members such as a connector or a metal terminal connected to an external device. Examples of the external device include a microphone and a speaker of a mobile device and a signal processing circuit component. On the surface of the component mounting portion 2, digital processing electronic components are mainly mounted. Meanwhile, the component mounting portion 223 on the bottom surface side mainly has analog processing electronic components. To be more specific, the component mounting portion 223 on the bottom surface side has electronic components such as a rectifying circuit configured to convert an alternate current generated by the transceiver circuit portion 13 to a direct current, an integrated circuit such as a voltage-transformation circuit configured to transform a voltage of a discharging current (direct current) of the secondary battery 222 to a driving voltage of the external device, a resistor, and a capacitor. The voltage-transformation circuit includes electronic components such as a resistor, a capacitor, and an inductor. In other words, the voltage-transformation circuit may be provided at the component mounting portion 2. The component mounting portion 223 further includes electronic components such as an integrated circuit such as a charging circuit configured to control the charging of the secondary battery 222, a resistor, and a capacitor. At both end portions in the width direction of the component mounting portion 2, electrode terminal portions 218 and 219 are provided through the intermediary of second wiring passage portions 216 and 217. The electrode terminal portions 218 and 219 are electrically connected to a positive electrode terminal and a negative electrode terminal, respectively. The positive electrode terminal and the negative electrode terminal are on one surface and the other surface of a button-shaped secondary battery 222, respectively.

The secondary battery 222 may be of any type as long as it is rechargeable. Various types of batteries including solid-state batteries may be employed as the secondary battery 222 in accordance with the type of the portable device 2. The secondary battery 222 is preferably a lithium ion battery. The nominal voltage of the lithium ion battery which falls within a range of 3.6V to 3.7V is higher than the nominal voltages of 1.2V to 1.4V of the air battery or the nickel-hydrogen secondary battery 222. Although the lithium ion battery exhibits a discharge characteristic such that its battery voltage drops from approximately 4.2V to approximately 2.7V, the lithium ion battery is able to drive a mobile device longer than the air cell or the nickel-hydrogen secondary battery 222, because the energy density of the lithium ion battery is higher than that of the air cell or the nickel-hydrogen secondary battery 222.

The mobile device encompasses a handheld device which can be carried on a hand and a human-wearable device which can be worn a human body. Specific examples of the mobile device include a portable computer (a laptop PC, a note PC, a tablet PC, or the like), a camera, an audio visual device (a portable music player, an IC recorder, a portable DVD player, or the like), a calculator (such as a pocket computer and an electronic calculator), a game console, a computer peripheral (a portable printer, a portable scanner, a portable modem, or the like), a dedicated information device (an electronic dictionary, an electronic notebook, an electronic book, a portable data terminal, or the like), a portable communication terminal, a voice communication terminal (a mobile phone, a PHS, a satellite phone, a third party radio system, an amateur radio, a specified low power radio, a personal radio, a citizen radio, or the like), a data communication terminal (a portable phone, a PHS (a feature phone and a smart phone), a pager, or the like), a broadcasting receiver (a television receiver and a radio), a portable radio, a portable television receiver, a one-seg receiver, another type of device (a wristwatch and a pocket watch), a hearing aid, a handheld GPS, a security buzzer, a flashlight/pen light, a battery pack, and the like. Examples of the above hearing aid include an ear-hook hearing aid, an ear hole fitting hearing aid, and a glasses-type hearing aid. The mobile device may have an IoT (Internet of Things) function.

The first wiring passage portion 212 and the second wiring passage portions 216 and 217 are provided with a first bending portion 213 and second bending portions 220 and 221, respectively. Each bending portion has a one side substrate structure. As the wireless power supply wiring circuit board 1 is bended at the first bending portion 213 and the second bending portions 220 and 221, a battery module 41 including the secondary battery 222 is formed.

To be more specific, the battery module 41 includes a housing 411 in which a button-shaped secondary battery 222 is accommodated. The housing 411 has a peripheral wall 411a supporting the side peripheral surface of the secondary battery 222 and a flat portion 411c that is formed by partially flattening the peripheral wall 411a so that the component mounting portion 2 is provided in a planar manner. When the wireless power supply wiring circuit board 1 is attached to the housing 411 accommodating the secondary battery 222, to begin with, the first bending portion 213 of the wireless power supply wiring circuit board 1 is positioned and made contact to an end portion of the flat portion 411c of the housing 411, and then the circuit board 1 is bended at this first bending portion 213 at right angles. As a result of this, the first wiring passage portion 212 and the transceiver circuit portion 13 on one side of the first bending portion 213 are provided along the peripheral wall 411a of the housing 411, whereas the component mounting portion 2 on the other side of the first bending portion 213 is provided along the flat portion 411c of the housing 411. In this way, the transceiver circuit portion 13 and the component mounting portion 2 are highly precisely positioned at predetermined positions of the housing 411. Thereafter, as the electrode terminal portions 218 and 219 are bended at the second bending portions 220 and 221 at right angles, the electrode terminal portions 218 and 219 are connected to the electrodes of the secondary battery 222.

Although the above descriptions have been provided with regard to the characteristic parts so as to understand the invention more easily, the invention is not limited to the embodiment as described above and can be applied to the other embodiments and the applicable scope should be construed as broadly as possible. Furthermore, the terms and phraseology used in the specification have been used to correctly illustrate the present invention, not to limit it. In addition, it will be understood by those skilled in the art that the other structures, systems, methods and the like included in the spirit of the present invention can be easily derived from the spirit of the invention described in the specification. Accordingly, it should be considered that the present invention covers equivalent structures thereof without departing from the spirit and scope of the invention as defined in the following claims. In addition, it is required to sufficiently refer to the documents that have been already disclosed, so as to fully understand the objects and effects of the present invention.

## Claims

1. A wireless power supply wiring circuit board comprising:
an insulating layer;
a conductive layer which is provided on one surface in a thickness direction of the insulating layer and includes a wiring portion;
a transceiver circuit portion which is electrically connected to the wiring portion;
a component mounting portion which is provided on an other surface in the thickness direction of the insulating layer, an electronic component electrically connected to the wiring portion being mounted on the component mounting portion; and
a dam portion which is made of metal and is provided around at least part of the component mounting portion.

2. The wireless power supply wiring circuit board according to claim 1, wherein,
the component mounting portion has a planar mounting surface on which the electronic component electrically connected to the wiring portion through a conductive portion is mounted, and
the conductive portion is flush with the mounting surface of the component mounting portion.

3. The wireless power supply wiring circuit board according to claim 1 or 2, wherein, the dam portion is rectangular in shape in cross section.

4. The wireless power supply wiring circuit board according to any one of the preceding claims, wherein, the dam portion is made of stainless steel.

5. The wireless power supply wiring circuit board according to any one of the preceding claims, wherein, height of the dam portion falls within a range of 1 µm to 100 µm.

6. The wireless power supply wiring circuit board according to any one of the preceding claims, wherein, a distance a between the component mounting portion and the dam portion and a vertical distance b between a top surface of the component mounting portion and a top surface of a package of an electronic component mounted on the component mounting portion satisfy a relationship of b/10<=a<=b.

7. A battery module comprising:
the wireless power supply wiring circuit board according to any one of claims 1 to 6; and
a battery which is connected to the wireless power supply wiring circuit board.
